(19) **Europäisches Patentamt**
**European Patent Office**
**Office européen des brevets**

(11) **EP 2 913 845 A1**

(12) **EUROPEAN PATENT APPLICATION**

(43) Date of publication:
**02.09.2015 Bulletin 2015/36**

(51) Int Cl.:
**H01L 21/311** (2006.01)   **H01J 37/32** (2006.01)
**C23C 16/44** (2006.01)

(21) Application number: **15156143.8**

(22) Date of filing: **23.02.2015**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **27.02.2014 JP 2014036382**

(71) Applicant: **TOKYO ELECTRON LIMITED
Minato-ku
Tokyo 107-6325 (JP)**

(72) Inventors:
• **UDA, Hiroshi
Kurokawa-gun, Miyagi 981-3629 (JP)**

• **TSUJIMOTO, Hiroshi
Kurokawa-gun, Miyagi 981-3629 (JP)**
• **HARADA, Akitoshi
Kurokawa-gun, Miyagi 981-3629 (JP)**
• **YAKUSHIJI, Hideaki
Kurokawa-gun, Miyagi 981-3629 (JP)**
• **SUGIYAMA, Masaharu
Kurokawa-gun, Miyagi 981-3629 (JP)**

(74) Representative: **Manitz, Finsterwald & Partner
GbR
Martin-Greif-Strasse 1
80336 München (DE)**

(54) **Cleaning method for plasma processing apparatus**

(57)    A Ti-containing remaining in a chamber of a plasma processing apparatus can be simply and efficiently removed. In a Low-k film etching process, immediately after a dry etching process (process $S_2$) is finished, a dry cleaning process is performed in the presence of a wafer while the wafer is held on an electrostatic chuck 40 (process $S_3$). The dry cleaning process (process $S_3$) is performed to mainly remove the Ti-containing reactant remaining in the chamber 10. To this end, a cleaning gas containing a $H_2$ gas and a $N_2$ gas is introduced into the chamber 10 from a processing gas supply unit 70 at a preset flow rate ratio. Then, a first high frequency power HF for plasma generation is applied to a susceptor 12 at a preset power level, so that plasma is generated within the chamber 10 by the high frequency discharge of the cleaning gas.

*FIG. 3*

EP 2 913 845 A1

## Description

## TECHNICAL FIELD

The embodiments described herein pertain generally to a cleaning method of cleaning an inside of a processing vessel of a plasma processing apparatus; and, more particularly, to a cleaning method of removing a Ti-containing reactant.

## BACKGROUND

In a recent semiconductor device, to meet the requirements for high speed and low power consumption thereof, a copper having lower resistance than aluminum is used as a wiring material, and a Low-k film (low dielectric film) capable of reducing an inter-wiring capacitance is used as an interlayer insulating film. As this kind of Low-k film, an inorganic material such as a SiOF film or a porous film has been positively considered, and an organic material such as amorphous carbon or fluorine resin having a relative permittivity equal to or less than 2.5 has been also attracting attention. Regardless of which the kind of the Low-k film, an etching mask made of a TiN film is widely utilized as a robust metal hard mask having higher etching resistance and higher etching selectivity during the etching of the Low-k film performed in BEOL (Back End Of Line) process as a wiring forming process in the manufacturing the semiconductor device. As in the etching of a $SiO_2$ film, a CF-based gas, *e.g.,* a $CF_4$ gas is widely used as an etching gas.

Patent Document 1: Japanese Patent Laid-open Publication No. 2003-282539

In a plasma etching apparatus, if the Low-k film is etched with the metal hard mask made of the TiN film, Ti-containing reactants (primarily, $Ti-F_x$, Ti-OF, or the like) are generated from the metal hard mask exposed to plasma of the CF-based gas to float within a processing vessel. Although many of these Ti-containing reactants are exhausted from the processing vessel along with other reaction products or an unreacted gas, some of these Ti-containing reactants may be left within the processing vessel.

The Ti-containing reactants left in the processing vessel adhere to an inner wall of the processing vessel or various components within the processing vessel. Especially, if a processed target object, for example, a processed semiconductor wafer is unloaded from the processing vessel upon the completion of a Low-k film etching process, a top surface, *i.e.,* a wafer mounting surface of a mounting table that has held the processing target object thereon up to that time is empty (*i.e.*, nothing is placed on the wafer mounting surface), and the Ti-containing reactants adhere to or are deposited on this empty wafer mounting surface, which is especially troublesome.

Once the Ti-containing reactants adhere to the wafer mounting surface of the mounting table, even if an electrostatic chuck provided on the mounting table attempts to attract and hold the semiconductor wafer as a processing target object by an electrostatic force, since the robust Ti-containing reactants are provided between the corresponding semiconductor wafer and the wafer mounting surface, a gap may be formed between the semiconductor wafer and the wafer mounting surface or the semiconductor wafer may be deviated from a correct position. If so, a heat transfer backside gas, which is supplied from gas discharge openings at the wafer mounting surface to a rear surface of the semiconductor wafer may be leaked out. Sometimes, when a transfer arm separates the processed semiconductor wafer from the wafer mounting surface of the mounting table after completing the etching process, the position deviation of the semiconductor wafer may be reflected on the transfer arm, so that a TNS (Transfer Navigation System) error may occur.

## SUMMARY

In view of the foregoing problems, example embodiments provide a cleaning method for a plasma processing apparatus, capable of removing a Ti-containing reactant left in a processing vessel of the plasma processing apparatus simply and efficiently.

In one example embodiment, a cleaning method of removing a Ti-containing reactant remaining in a processing vessel of a plasma processing apparatus includes a first dry cleaning process of introducing a first cleaning gas containing a $H_2$ gas and a $N_2$ gas into the processing vessel in a depressurized state while evacuating the processing vessel; generating plasma by electrically discharging the first cleaning gas; allowing one of active species in the plasma to react with the Ti-containing reactant to generate a reaction product; and exhausting the reaction product from the processing vessel.

In this cleaning method described above, hydrogen-based active species contained in the plasma react with the Ti-containing reactant remaining in the processing vessel in the first dry cleaning process, so that a volatile reaction product is generated. Meanwhile, nitrogen-based active species contained in the plasma hardly make a direct chemical reaction with the Ti-containing reactant. Rather, the nitrogen-based active species serve to accelerate or appropriately suppress a chemical reaction between the hydrogen-based active species and the Ti-containing reactant. The Ti-containing reaction product generated from above is discharged from the processing vessel along with other reaction products or an unreacted gas.

In the example embodiment, the term "active species" means species that make a chemical or physical reaction with another atom or molecule. The active species includes excited atoms, radicals and ions.

According to the cleaning method of the example embodiment, with the above-described configuration and operation, the Ti-containing reactant remaining in the processing vessel of the plasma processing apparatus can be removed simply and efficiently.

The foregoing summary is illustrative only and is not intended to be in any way limiting. In addition to the illustrative aspects, embodiments, and features described above, further aspects, embodiments, and features will become apparent by reference to the drawings and the following detailed description.

## BRIEF DESCRIPTION OF THE DRAWINGS

In the detailed description that follows, embodiments are described as illustrations only since various changes and modifications will become apparent to those skilled in the art from the following detailed description. The use of the same reference numbers in different figures indicates similar or identical items.

FIG. 1 is a cross sectional view illustrating a configuration example of a plasma processing apparatus in which a cleaning method of an example embodiment is performed;

FIG. 2A to FIG. 2D are diagrams schematically illustrating major processes of an etching process through a multilayer resist method performed in BEOL in the course of manufacturing a semiconductor device;

FIG. 3 is a flowchart depicting detailed processes of a Low-k film etching process in accordance with the example embodiment;

FIG. 4 is a graph showing a Ti contamination amount reducing effect on a wafer mounting surface within a chamber, through the comparison between an experimental example in which dry cleaning is performed in the presence of a wafer and a comparative example in which purging is performed in the presence of a wafer;

FIG. 5 is a graph showing Ti deposition amounts at individual positions in a diametrical direction of a measurement wafer in a case (experimental example) where the Low-k film etching process including all of five processes (processes $S_1$ to $S_5$) is performed repeatedly and a case (comparative example) where the Low-K film etching process including only four processes (processes $S_1$, $S_2$, $S_4$ and $S_5$) without including the dry cleaning process (process $S_3$) performed in the presence of the wafer is performed repeatedly;

FIG. 6 is a flowchart showing a sequence of a seasoning process in accordance with the example embodiment; and

FIG. 7 is a graph showing the Ti contamination amount reducing effects on the wafer mounting surface within the chamber, while varying, as parameters, the kind and a flow rate of a cleaning gas supplied in the dry cleaning process performed in the presence of a wafer.

## DETAILED DESCRIPTION

In the following detailed description, reference is made to the accompanying drawings, which form a part of the description. In the drawings, similar symbols typically identify similar components, unless context dictates otherwise. Furthermore, unless otherwise noted, the description of each successive drawing may reference features from one or more of the previous drawings to provide clearer context and a more substantive explanation of the current example embodiment. Still, the example embodiments described in the detailed description, drawings, and claims are not meant to be limiting. Other embodiments may be utilized, and other changes may be made, without departing from the scope of the subject matter presented herein. It will be readily understood that the aspects of the present disclosure, as generally described herein and illustrated in the drawings, may be arranged, substituted, combined, separated, and designed in a wide variety of different configurations, all of which are explicitly contemplated herein.

Hereinafter, example embodiments will be described with reference to the accompanying drawings, which form a part of the description.

[Overall configuration of apparatus]

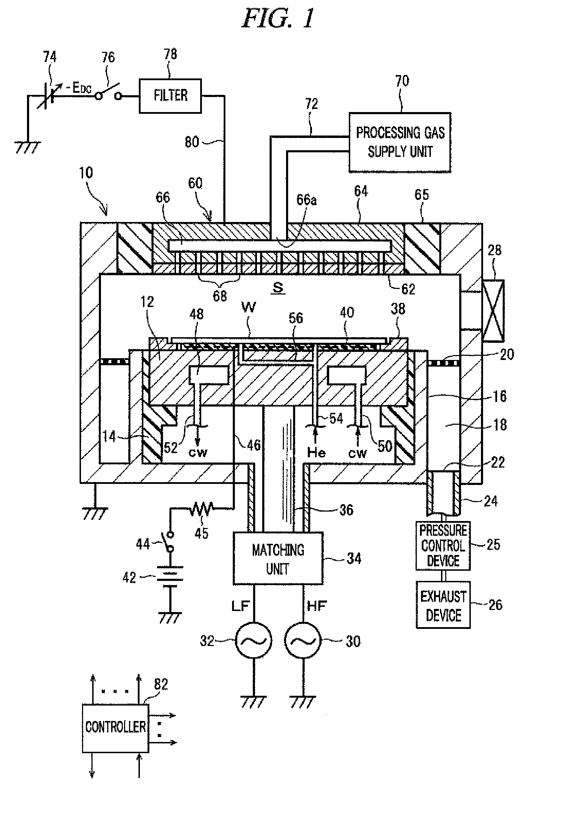

FIG. 1 depicts a configuration example of a plasma processing apparatus in which a cleaning method of an example embodiment is performed. This plasma processing apparatus is configured as a cathode-coupled capacitively coupled plasma etching apparatus configured to apply dual high frequency powers to a lower electrode. The plasma processing apparatus includes a cylindrical chamber (processing vessel) 10 made of a metal such as, but not limited to, aluminum or stainless steel. The chamber 10 is frame-grounded.

A substantially circular plate-shaped or cylindrical susceptor 12 configured to mount thereon, *e.g.*, a semiconductor wafer W as a processing target substrate is horizontally provided within the chamber 10. The susceptor 12 serves as a lower electrode. The susceptor 12 is made of, *e.g.,* aluminum and is supported on an insulating cylindrical supporting member 14 vertically extended from a bottom of the chamber 10. An annular exhaust path 18 is formed between a side wall of the chamber 10 and a conductive cylindrical supporting member (inner wall member) 16 vertically extended upward from the bottom of the chamber 10 along a periphery of the cylindrical supporting member 14. A ring-shaped baffle plate (exhaust ring) 20 is fastened to an inlet portion of the exhaust path 18, and a single or a multiple number of exhaust openings 22 is formed at a bottom portion of the exhaust path 18. An exhaust device 26 is connected to the exhaust opening 22 via an exhaust pipe 24 and a pressure control device 25 such as an APC valve. The exhaust device 26 includes a vacuum pump such as a turbo molecular pump. The pressure control device 25 is configured to adjust a pressure within the chamber 10 by adjusting an exhaust amount of the exhaust device 26. A plasma generation space S within the chamber 10 can be depressurized to a required vacuum level by the pressure control device 25 and the exhaust device 26. Further, by operating the exhaust device 26, a gas can be exhausted toward the gas exhaust device 26 from the vicinity of the susceptor 12 through the exhaust path 18 and the exhaust opening 22. A gate valve 28 configured to open and close a loading/unloading opening for the semiconductor wafer W is provided at the sidewall of the chamber 10.

A first high frequency power supply 30 and a second high frequency power supply 32 are electrically connected to the susceptor 12 via a matching unit 34 and a power feed rod 36. Here, the first high frequency power supply 30 is configured to output a first high frequency power HF of a certain frequency (desirably, equal to or higher than 27 MHz), e.g., 40 MHz, suitable for high frequency discharge of a processing gas, i.e., plasma generation. The second high frequency power supply 32 is configure to output a second high frequency power LF of a certain frequency (desirably, equal to or lower than 13.56 MHz), e.g., 2 MHz, suitable for controlling energy of ions mainly attracted to the semiconductor wafer W on the susceptor 12. The matching unit 34 accommodates therein a first matching device configured to match impedance on the side of the first high frequency power supply 30 and a load impedance (mainly, electrode, plasma and chamber); and a second matching device configured to match impedance on the side of the second high frequency power supply 32 and the load impedance.

The susceptor 12 has a diameter much larger than that of the semiconductor wafer W. On a top surface of the susceptor 12, the semiconductor wafer W as the processing target object is mounted, and a focus ring (correction ring) 38 is provided to surround the semiconductor wafer W. The focus ring 38 is made of a conductive material such as, but not limited to, Si or SiC having little influence on a process. Further, the focus ring 38 as a consumable component is detachably fastened on the top surface of the susceptor 12.

An electrostatic chuck 40 configured to attract and hold a wafer is provided on the top surface of the susceptor 12. The electrostatic chuck 40 includes a sheet-shaped or mesh-shaped conductor embedded in a film-shaped or plate-shaped dielectric member. The conductor is electrically connected with a DC power supply 42, which is provided outside the chamber 10, via a switch 44, a resistor 45 and a power supply line 46. The semiconductor wafer W can be attracted to and held on the electrostatic chuck 40 by an electrostatic force generated by applying a DC voltage from the DC power supply 42.

An annular coolant path 48 extended in, for example, a circumferential direction is formed within the susceptor 12. A coolant of a preset temperature, e.g., cooling water cw is supplied into and circulated through the coolant path 48 via pipelines 50 and 52 from a chiller unit (not shown). A heater (not shown) may be further provided within the susceptor 12. A temperature of the semiconductor wafer W on the electrostatic chuck 40 can be controlled by adjusting the temperature and a flow rate of the coolant and, also, by heating the heater. Further, a heat transfer backside gas such as, but not limited to, a He gas is supplied into a gap between the electrostatic chuck 40 and the semiconductor wafer W through a gas supply line 54 and a gas passage 56 within the susceptor 12 from a heat transfer gas supply unit (not shown) in order to further improve the accuracy of the wafer temperature.

A shower head 60 serving as an upper electrode is provided at a ceiling portion of the chamber 10 to face the susceptor 12 in parallel. The shower head 60 includes an electrode plate 62 directly facing the susceptor 12; and an electrode supporting member 64 configured to support the electrode plate 62 from a backside thereof (from above it in the drawing) in a detachable manner. A gas diffusion space 66 is formed within the electrode supporting member 64, and a multiple number of gas discharge holes 68 extended from the gas diffusion space 66 toward the susceptor 12 are formed through the electrode supporting member 64 and the electrode plate 62. A space between the electrode plate 62 and the susceptor 12 serves as a plasma generation space or a processing space S. A gas supply line 72 led from a processing gas supply unit 70 is connected to a gas inlet opening 66a formed at a top portion of the diffusion space 66. Further, the electrode plate 62 may be made of, by way of example, but not limitation, Si or SiC, and the electrode supporting member 64 may be made of, by way of example, but not limitation, alumite-treated aluminum.

A ring-shaped insulator 65 is inserted between the shower head (upper electrode) 60 and the chamber 10, and the shower head (upper electrode) 60 is fastened to the chamber 10 in an electrically floating state. Further, there is provided a DC power supply 74 configured to supply a negative, desirably, variable DC voltage $-E_{DC}$ to the upper electrode 60. An output terminal of the DC power supply 74 is electrically connected with the upper electrode 60 via a switch 76, a filter circuit 78 and a DC power supply line 80. The filter circuit 78 is configured to allow the DC voltage $-E_{DC}$ from the DC power supply 74 to be applied to the upper electrode 60. Also, the filter circuit 78 is configured to flow a high frequency power supplied to the DC power supply line 80 from the susceptor 12 through the processing space S and the upper electrode 60 toward a grounding line while suppressing the high frequency power to be flown to the DC power supply 74. Further, a DC grounding part (not shown) made of a conductive material such as, but not limited to, Si or SiC is provided at a position of the chamber 10 directly facing the processing space S. The DC grounding part is grounded via a grounding line (not shown).

A controller 82 includes a microcomputer and various kinds of interfaces. The controller 82 controls an overall operation (sequence) of the plasma etching apparatus and operations of individual components within the plasma etching apparatus, *e.g.,* the exhaust device 24, the high frequency power supplies 30 and 32, the matching unit 34, the switch 44, the processing gas supply units 70 and 76, the (variable) DC power supply 74, the chiller unit (not shown) and the heat transfer gas supply unit (not shown) according to software (program) and recipe information stored in an external or internal memory unit. In the shown example, the controller 82 is illustrated as a single control unit. However, it may be also possible to adopt a configuration in which a multiple number of control units divide up the functions of the controller 82 in parallel or hierarchically.

A basic operation of a single-sheet dry etching process in the plasma etching apparatus having the above-described configuration is performed as follows. First, the gate valve 28 is opened, and the semiconductor wafer W to be processed is loaded into the chamber 10 and mounted on the electrostatic chuck 40. Then, the chamber 10 is hermetically sealed, and an etching gas (generally, a mixture gas) is introduced into the chamber 10 from the processing gas supply unit 70 at a preset flow rate and a preset flow rate ratio. A pressure within the chamber 10 is regulated to a set value by the exhaust device 26 and the pressure control device 25. Further, the first high frequency power HF and the second high frequency power LF are outputted from the first and second high frequency power supplies 30 and 32, respectively, and these high frequency powers HF and LF are applied to the susceptor 12 via the matching unit 34 and the power feed rod 36. Further, when necessary, the switch 76 may be turned on, and the negative DC voltage $-E_{DC}$ may be applied from the DC power supply 74 to the shower head (upper electrode) 60. In addition, a backside gas (He) is supplied to an interface between the electrostatic chuck 40 and the semiconductor wafer W from a heat transfer gas supply unit, and, at the same time, by turning on the switch 44, the backside gas (He) is confined in that interface by an electrostatic attracting force of the electrostatic chuck 40. The etching gas discharged to the plasma generation space S from the shower head 60 is electrically discharged under a high frequency electric field to be exited into plasma. A processing target film on the surface of the semiconductor wafer W is etched into a desired pattern by radicals or ions included in the plasma of the etching gas.

In this plasma etching apparatus, by applying the first high frequency power HF having a relatively high frequency (equal to or higher than 27 MHz) suitable for plasma generation to the susceptor 12, the plasma becomes highly denser in a desirable dissociated state. Accordingly, the high-density plasma can be generated under a lower pressure condition. Further, by applying the second high frequency power LF having a relatively low frequency (equal to or lower than 13.56 MHz) suitable for ion attraction to the susceptor 12, anisotropic etching having a high selectivity can be performed on the semiconductor wafer W mounted on the susceptor 12. Here, the first high frequency power HF for plasma generation is necessary in any plasma process within the chamber 10, whereas the second high frequency power LF for ion attraction may not be applied depending on the kind of a process performed.

[Example of Low-k film etching process in example embodiment]

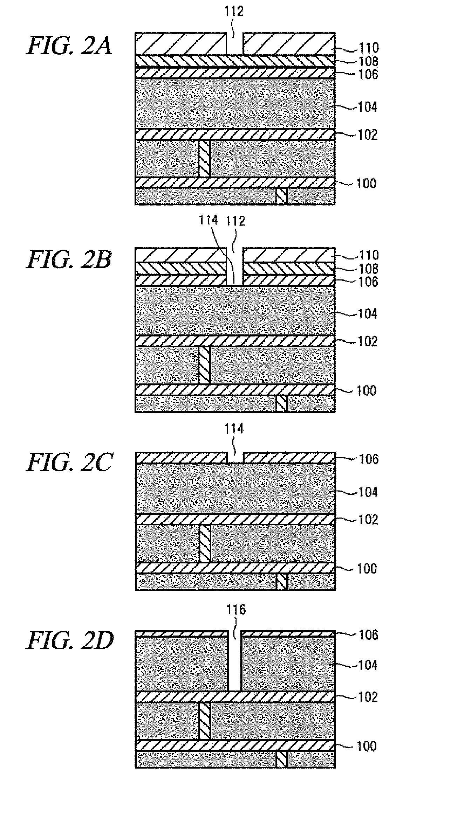

**FIG. 2A** to **FIG. 2D** schematically illustrate major processes of an etching process through a multilayer resist method performed in BEOL in the course of manufacturing a semiconductor device. Among these processes, an etching process of etching a Low-k film (interlayer insulating film) with a TiN layer as an etching mask can be performed in the plasma etching apparatus **(FIG. 1)** described above.

As depicted in **FIG. 2A,** a (n-1)th wiring 100 and a nth wiring 102 thereon are previously formed on the semiconductor wafer W to be processed. To form a next upper wiring, *i.e.,* a (n+1)th wiring (not shown), a Low-k film (interlayer insulating film) 104, a TiN layer 106, a bottom antireflection coating (BARC) layer 108 and a photoresist 110 are formed on the nth wiring 102 in sequence. Here, the Low-k film 104 and the bottom antireflection coating layer 108 are formed through the spin coating method or the CVD (Chemical Vapor Deposition) method. The TiN layer 106 is formed through the sputtering method. The photoresist 110 has a pattern through the photolithography and is provided with an opening 112. The opening 112 is located directly above a position where a via hole is to be formed in the Low-k film 104.

First, in this multilayer resist method, to transcribe the pattern of the photoresist 110 to the TiN layer 106, the bottom antireflection coating layer 108 is etched with the photoresist 110 as an etching mask in another plasma etching apparatus. In case that the bottom antireflection coating layer 108 is made of polymer resin, a mixture gas containing, by way of non-limiting example, a $HF_3$ gas and a HBr gas is used as the etching gas for etching the bottom antireflection coating layer 108. Subsequently, in the same or another plasma etching apparatus, the TiN layer 106 is etched with the photoresist 110 and the bottom antireflection coating layer 108 as an etching mask. When etching this TiN layer 106, a mixture gas containing, by way of non-limiting example, a $Cl_2$ gas and a $N_2$ gas is used as an etching gas.

Accordingly, as depicted in **FIG. 2B,** the opening pattern of the photoresist 110 is transcribed to the TiN layer 106 through the bottom antireflection coating layer 108, and an opening 114 is formed in the TiN layer 106 at a position corresponding to the opening 112 of the photoresist 110. Thereafter, in a plasma ashing apparatus, the photoresist 110 and the bottom antireflection coating layer 108 are peeled off or removed by performing the ashing process with plasma of an $O_2$ gas. As a result, the TiN layer 106 having the opening 114 is exposed on the surface of the semiconductor wafer W, as depicted in **FIG. 2C.**

In the plasma etching apparatus **(FIG. 1)** in accordance with the present example embodiment, the semiconductor wafer W, in which the TiN layer 106 patterned through the multilayer resist method is exposed on the surface thereof as described above, is used as a processing target object, and the Low-k film 104 is etched with the TiN layer 106 as the etching mask. When etching the Low-k film 104, a CF-based gas, *e.g.,* a mixture gas containing a $CF_4$ gas and an Ar gas is used as the etching gas. Through this dry etching process, a through hole or a via hole 116 is formed in the Low-k film 104 at a position corresponding to the opening 114 of the TiN layer 106, as depicted in **FIG. 2D.**

Thereafter, the TiN layer 106 left on the surface of the semiconductor wafer W, *i.e.,* a residual film of the etching mask is removed through, for example, a wet process using hydrofluoric acid. A conductive metal, *e.g.,* copper is buried in the via hole 116 and the $(n+1)^{th}$ wiring is formed on a top surface of the Low-k film 104.

[Details of Low-k film etching process in example embodiment]

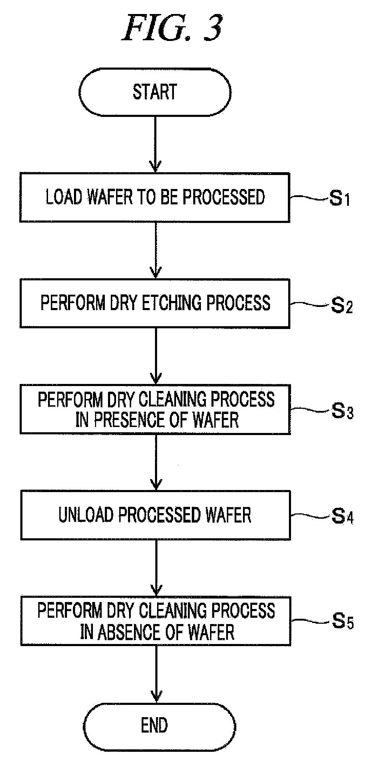

To elaborate, the above-described etching process of the Low-k film 104 performed in the plasma etching apparatus is divided into a multiple number of processes (processes $S_1$ to $S_5$), as shown in **FIG. 3.**

First, the semiconductor wafer W, in which the TiN layer 106 exposed on the surface thereof, is loaded into the chamber 10 as the processing target object (process $S_1$ (load wafer to be processed)) and mounted on the electrostatic chuck 40, as shown in **FIG. 2C.** Then, the etching gas containing the $CF_4$ gas and the Ar gas is started to be supplied from the processing gas supply unit 70, and a pressure within the chamber 10 is controlled to a set value by the gas exhausting operation of the exhaust units 25 and 26. Further, temperatures of the individual components within the chamber 10 are controlled to preset values by a temperature control device including the chiller unit, the heater, the heat transfer gas supply unit, and so forth.

Then, after the pressure control and the temperature control are completed, the first and second high frequency power supplies 30 and 32 are turned on, and, when necessary, the switch 76 for applying the DC bias $-E_{DC}$ to the upper electrode is turned on, so that the dry etching process of forming the via hole 116 in the Low-k film 104 is begun (process $S_2$ (perform dry etching process)).

In this dry etching process (process $S_2$), plasma is generated as a result of the high frequency discharge of the etching gas in the processing space S within the chamber 10. Active species of the plasma, particularly, fluorine radicals or argon ions react with a material of the Low-k film 104 chemically or physically, so that volatile reaction products are generated. Although many of these reaction products are exhausted by the exhaust units 25 and 26, some of them may be left within the chamber 10. As a result, the left reaction products may float in the processing space S or adhere to the inner wall of the chamber 10 or components therein such as the susceptor 12.

Meanwhile, the active species of the plasma, particularly, the fluorine radicals or the argon ions also react chemically or physically with the TiN layer 106 serving as the etching mask, so that volatile reaction products are generated. Although many of these reaction products are also exhausted by the exhaust units 25 and 26, some of them may remain within the chamber 10. As a result, the left reaction products may float in the processing space S or adhere to the inner wall of the chamber 10 or various components therein such as the susceptor 12. These reaction products include a Ti-containing reactant such as $Ti\text{-}F_x$ or Ti-OF.

If the via hole 116 formed in the Low-k film 104 reaches the underlying $n^{th}$ wiring 102, the dry etching process (process $S_2$) is finished through preset etching end point detection. That is, the high frequency power supplies 30 and 32 are turned off. Further, if the DC voltage $-E_{DC}$ is being applied to the shower head (upper electrode) 60 from the DC power supply 74 in this process, the switch 76 is turned off. Further, the gas supply from the processing gas supply unit 70 is stopped. However, the gas exhausting operation of the exhausting units 25 and 26 is continued.

In this example embodiment, immediately after the dry etching process (process $S_2$) is finished, a dry cleaning process is performed in the state that the semiconductor wafer W is still held on the susceptor 12, that is, a dry cleaning process in the presence of the wafer is performed (process $S_3$ (perform dry cleaning process in presence of wafer)).

This dry cleaning process (process $S_3$) in the presence of the wafer is performed to mainly remove the Ti-containing reactant remaining in the chamber 10. To this end, a cleaning gas containing a $H_2$ gas and a $N_2$ gas is introduced into the chamber 10 from the processing gas supply unit 70 at a certain flow rate ratio (desirably, in the range from 1:0 to 1:3). Then, after controlling a pressure within the chamber 10, the high frequency power supply 30 is turned on, and the first high frequency power HF for plasma generation is applied to the susceptor 12 at a preset power level, so that plasma is generated within the chamber 10 as a result of the high frequency discharge of the cleaning gas. Further, since this dry cleaning process (process $S_3$) is a process in which, among various active species of the plasma, chemical reaction of radicals are mainly dominant, ions in the plasma need not be attracted to the semiconductor wafer W mounted on the susceptor 12, and there is no particular need to perform the sputtering method by bringing the ions into contact with the electrode plate 62 of the shower head 60. Thus, typically, the second high frequency power supply 32 and the DC power supply 74 are maintained off.

In this dry cleaning process (process $S_3$) performed in the presence of the wafer, hydrogen-based active species, *i.e.*, any one of excited hydrogen atoms, hydrogen radicals and hydrogen ions included in the plasma of the cleaning gas react well with the Ti-containing reactant such as Ti-$F_x$ or Ti-OF floating in the chamber 10 or adhering to a certain place within the chamber 10, so that Ti-containing volatile reaction products such as TiH are generated. Meanwhile, nitrogen-based active species, *i.e.*, excited nitrogen atoms, nitrogen radicals and nitrogen ions included in the plasma hardly make a direct chemical reaction with the Ti-containing reactant but rather serve to accelerate or appropriately suppress the chemical reaction between the hydrogen-based active species and the Ti-containing reactant. The Ti-containing reaction products thus generated are exhausted from the chamber 10 along with other reaction products or a non-reacted gas through the exhaust units 25 and 26.

Desirably, this dry cleaning process (process $S_3$) performed in the presence of the wafer needs to be conducted for a preset processing time of, desirably, 8 seconds or more in order to achieve a practical Ti contamination amount reducing effect. Most or many of the Ti-containing reaction products generated within the chamber 10 through the dry etching process (process $S_2$) can be effectively removed through this dry cleaning process (process $S_3$) performed in the presence of the wafer. Further, other fluorine-based reactants, particularly, hydrogen fluorine (HF) generated by a reaction between fluorine and $H_2O$ molecules, generated within the chamber 10 through the dry etching process (process $S_2$) may easily damage the Low-k film. Such undesirable fluorine-based reactants are also removed together with the Ti-containing reactant through this dry cleaning process (process $S_3$) performed in the presence of the wafer.

The dry cleaning process (process $S_3$) in the presence of the wafer is ended by turning off the first high frequency power supply 30. Immediately after then, the gas supply from the processing gas supply unit 70 is stopped. However, the gas exhausting operation of the exhaust units 25 and 26 is still continued.

Typically, the plasma etching apparatus (FIG. 1) is connected via the gate valve 28 to a transfer chamber (not shown) which is constantly maintained in a depressurized state. A transfer arm (not shown) provided within this adjacent transfer chamber is configured to be introduced into or retracted out of the chamber 10 through the opened gate valve 28 in order to load or unload the semiconductor wafer W.

Upon the completion of the dry cleaning process (process $S_3$) performed in the presence of the wafer, the gate valve 28 is immediately opened while maintaining the depressurized state within the chamber 10, and the processed semiconductor wafer W is unloaded by the transfer arm (process $S_4$ (unload processed wafer)).

If the processed semiconductor wafer W is unloaded from the chamber 10, the top surface, *i.e.*, the wafer mounting surface of the electrostatic chuck 40 is empty, In the present example embodiment, a dry cleaning process is performed in this state that no semiconductor wafer is mounted on the electrostatic chuck 40. That is, a dry cleaning process in the absence of the wafer is performed as a final post-process (process $S_5$ (perform dry cleaning process in absence of wafer)).

The dry cleaning process (process $S_5$) in the absence of the wafer is performed primarily to mainly remove organic floating particles or deposit films remaining in the chamber 10. For the purpose, a cleaning gas containing an $O_2$ gas is introduced into the chamber 10 from the processing gas supply unit 70. Then, after controlling a pressure within the chamber 10, the first high frequency power supply 30 is turned on, and the first high frequency power HF for plasma generation is applied to the susceptor 12 at a preset power level, so that plasma is generated within the chamber 10 as a result of the high frequency discharge of the cleaning gas. In this dry cleaning process (process $S_5$) performed in the absence of the wafer, ions in the plasma need not be attracted to the electrostatic chuck 40 on which no wafer is mounted, and there is no particular need to perform the sputtering method by bringing the ions into contact with the electrode plate 62 of the shower head 60. Thus, typically, the second high frequency power supply 32 and the DC power supply 74 are maintained off.

In this dry cleaning process (process $S_5$) performed in the absence of the wafer, oxygen radicals included in the plasma react with the organic floating particles or the deposit films within the chamber 10, so that volatile reaction products are generated. These reaction products are exhausted from the chamber 10 through the exhaust units 25 and 26 along with other reaction products, a non-reacted gas, and so forth. In this case, since the Ti-containing reactant scarcely exists or, if any, exists only in a little amount, the Ti-containing reactant hardly diffuses or adheres to the wafer mounting surface of the electrostatic chuck 40 within the chamber 10 during the dry cleaning process (process $S_5$), or even if such diffusion or adhesion takes place, the amount of the diffusion or adhesion is very small.

When the above-described dry cleaning process (process $S_5$) performed in the absence of the wafer is ended, all processes of the Low-k film etching process on the single sheet of semiconductor wafer W are completed. Then, the same processes (processes $S_1$ to $S_5$) are repeated on a next semiconductor wafer W, which has, as depicted in **FIG. 2C,** a TiN layer 106 exposed on a surface thereof, in the same way as described above.

[Operation and effect in example embodiment (Verification experiment 1)]

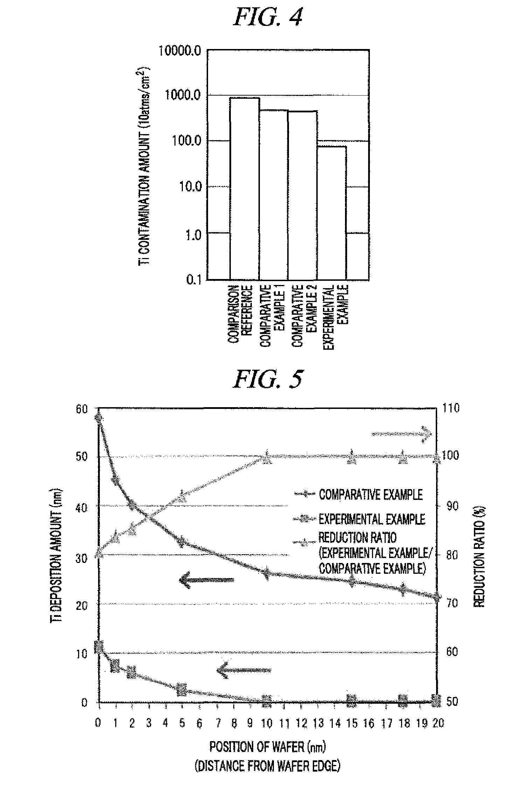

In the third process (process $S_3$) of the Low-k film etching process performed in the above-described plasma etching apparatus **(FIG. 1),** the present inventors have conducted an experiment (experiment example) in which the inside of the chamber 10 is cleaned by using plasma of a cleaning gas containing a $H_2$ gas and a $N_2$ gas as stated above and experiments (comparative examples 1 and 2) in which the inside of the chamber 10 is ventilated by flowing an inert gas (an Ar gas, a $N_2$ gas) into the chamber 10 without generating plasma thereof. Then, in each of the experiments, the amount of Ti contaminants (10 atms/cm$^2$) adhering to the wafer mounting surface of the electrostatic chuck 40 is measured after all processes of the Low-k film etching process are completed. Then, measurement results are compared. **FIG. 4** depicts a result of this verification experiment. In this verification experiment, processing conditions for the experimental example and the comparative examples 1 and 2 are as specified as follows.

> <Processing conditions for experimental example>
> Pressure within the chamber: 150 mTorr
> High frequency powers: HF = 400 W, LF = 0 W
> Cleaning gas: $H_2/N_2$ = 100 sccm/300 sccm
> Processing time: 30 seconds
> <Processing conditions for comparative example 1>
> Pressure within the chamber: 20 mTorr
> High frequency powers: HF = 0 W, LF = 0 W
> Purging gas: Ar = 1000 sccm
> Processing time: 30 seconds
> <Processing conditions for comparative example 2>
> Pressure within the chamber: 20 mTorr
> High frequency powers: HF = 0 W, LF = 0 W
> Purging gas: $N_2$ = 1000 sccm
> Processing time: 30 seconds

Further, processing conditions for the fifth process, *i.e.*, the dry cleaning process (process $S_5$) performed in the absence of the wafer are the same (common) in the experimental example and the comparative examples 1 and 2. The processing conditions are as follows.

> <Processing conditions for cleaning process performed in the absence of the wafer>
> Pressure within the chamber: 400 mTorr
> High frequency powers: HF = 400 W, LF = 0 W
> Cleaning gas: $O_2$ = 1500 sccm
> Processing time: 36 seconds

As depicted in **FIG. 4,** as compared to a case (comparison reference) in which the third process (process $S_3$) is omitted, *i.e.,* in which neither the cleaning nor the purging in the presence of the wafer is performed, a Ti contamination amount is found to be reduced to only about 1/2 in the comparative examples 1 and 2, but, on the other hand, the Ti-contamination amount is found to be reduced to 1/10 or less in the experiment example.

[Operation and effect in experimental example (Verification experiment 2)]

To investigate the effect of the third process of the Low-k film etching process performed in the plasma etching apparatus **(FIG. 1),** *i.e.,* the dry cleaning process (process $S_3$) performed in the presence of the wafer, the present inventors have conducted an experiment in which the Low-k film etching process (single-sheet process) including all of the five processes (processes $S_1$ to $S_5$) is performed on seven hundred (700) sheets of semiconductor wafers W repeatedly and, also, an experiment (comparative example) in which the Low-k film etching process (single-sheet process) including only four processes (processes $S_1$ and $S_2$ and processes $S_4$ and $S_5$), except the third process, *i.e.*, the dry cleaning process (process $S_3$) performed in the presence of the wafer, is repeatedly on seven hundred (700) sheets of semiconductor wafers W. Then, in each of the experiments, Ti deposition amounts at individual positions of a measurement wafer in a diametrical direction are measured, and the measurement results are compared. FIG. 5 depicts a result of this verification experiment.

In this verification experiment, in the dry cleaning process (process $S_5$) performed in the absence of the wafer, the measurement wafer having the same shape as that of the semiconductor wafer W is mounted on the wafer mounting surface of the electrostatic chuck 40, and, as a result of the Low-k film etching process on the seven hundred (700) sheets of semiconductor wafers W, Ti deposition amounts at individual positions on the measurement wafer in the diametrical direction are regarded as Ti deposition amounts at individual positions on the wafer mounting surface of the electrostatic chuck 40 in the diametrical direction. Processing conditions for the dry cleaning process (process $S_3$) in the presence of the wafer and the dry cleaning process (process $S_5$) in the absence of the wafer are the same as those described in the verification experiment 1.

Further, in this verification experiment 2, a seasoning process is performed, as in an actual process, whenever twenty (20) sheets of semiconductor wafers W are processed.

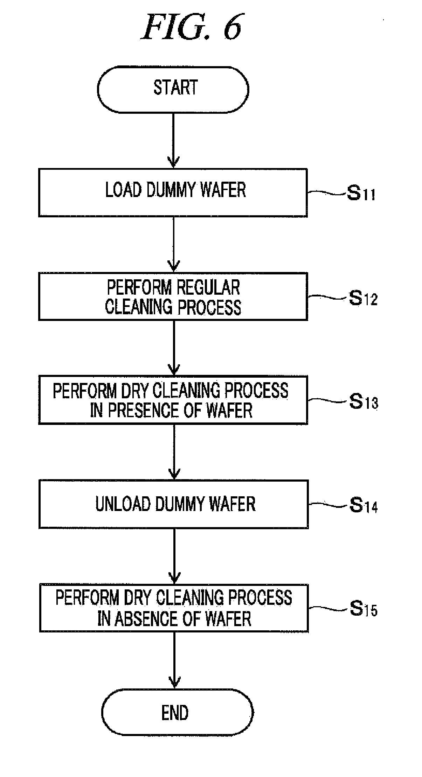

**FIG. 6** shows the sequence of the seasoning process. In the seasoning process, a dummy wafer having the same shape as that of the semiconductor wafer W as the processing target object is used instead of the semiconductor wafer W, and, in a second process (process $S_{12}$), regular cleaning or initialization of the inside of the chamber 10 is performed by using plasma of a preset cleaning gas, instead of the dry etching process. In other processes (process $S_{11}$ and processes $S_{13}$ to $S_{15}$), substantially the same processes or operations as the above-described Low-k film etching process are performed. In the regular cleaning process (process $S_{12}$), an organic deposit film within the chamber 10 is removed by using, for example, a cleaning gas containing an $O_2$ gas or a cleaning gas containing an $O_2$ gas and a CF-based gas is performed.

As depicted in **FIG. 5,** in the comparative example without performing the cleaning process (process $S_3$) in the presence of the wafer, the Ti deposition amount is found to have the largest value of about 60 nm in the vicinity of an edge of the measurement wafer. Although the Ti deposition amount gradually decreases toward a center thereof, there is still found the Ti deposition amount equal to or larger than 20 nm at a position 20 mm inwards from the edge of the measurement wafer. Meanwhile, in the experimental example, although it is the same as in the comparative example that the Ti deposition amount has the largest value in the vicinity of the edge of the measurement wafer and decreases toward the center thereof, an absolute value of the Ti deposition amount at each position thereof is found to be remarkably decreased in the experimental example. That is, the Ti deposition amount is only 12 nm in the vicinity of the edge of the measurement wafer and substantially zero (0) nm at a position 10 mm or more inwards from the edge thereof.

Accordingly, if the Ti deposition amount at each position on the wafer in the diametrical direction in the comparative example and in the experimental example is denoted by A and B, respectively, a reduction ratio C of the experimental example with respect to the comparative example is represented by the following equation (1).

$$C = 100\% \times (B - A) / B \quad \cdots \quad (1)$$

As can be seen from **FIG. 5,** the reduction ratio C has the value of about 80 % in the vicinity of the edge of the wafer, and is about 100 % at a position 10 mm or more inwards from the edge thereof. That is, the reduction ratio C is equal to or larger than 80 % (C ≥ 80 %), and it is proved that the Ti deposition amount can be greatly reduced in the experimental example.

[Operation and effect in example embodiment (Verification experiment 3)]

To determine a cleaning gas used in the dry cleaning process (process $S_3$) performed in the presence of the wafer in accordance with the example embodiment, the present inventors have conducted an experiment in which the amount of Ti contaminants (10 atms/cm$^2$) adhering to the wafer mounting surface of the electrostatic chuck 40 is measured after all processes of the Low-k film etching process on a single sheet of semiconductor wafer W is completed, as in the verification experiment 1 described above, while varying the kind of the cleaning gas and the flow rate of the cleaning gas as parameters. Then, the measurement results are compared.

Different gas conditions and other common processing conditions in experimental examples 1, 2 and 3 and comparative examples 1, 2 and 3 in the dry cleaning process performed in the presence of the wafer are specified as follows. Further, processing conditions for the dry

cleaning process (process $S_5$) performed in the absence of the wafer are the same as those in the verification experiment 1.

    <Experimental example 1>
Cleaning gas: $H_2$ = 400 sccm
<Experimental example 2>
Cleaning gas: $H_2/N_2$ = 100 sccm/300 sccm
<Experimental example 3>
Cleaning gas: $H_2/N_2$ = 200 sccm/200 sccm
<Comparative example 1>
Cleaning gas: $CHF_3/O_2$ = 23 sccm/1500 sccm
<Comparative example 2>
Cleaning gas: $N_2$ = 400 sccm
<Comparative example 3>
Cleaning gas: Ar = 800 sccm
<Common processing conditions>
Pressure within the chamber: 150 mTorr
High frequency power: HF = 400 W, LF = 0 W
Processing time: 30 seconds

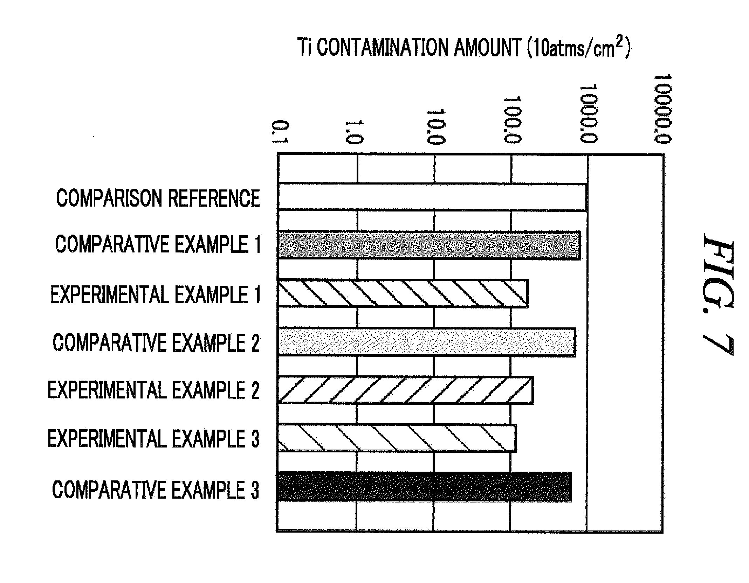

As depicted in **FIG. 7,** as compared to a case (comparison reference) in which the third process (process $S_3$) is omitted, *i.e.,* in which neither the cleaning nor the purging in the presence of the wafer is performed, a Ti contamination amount is found to be reduced to only about 20 % in the comparative examples 1 2 and 3, but, on the other hand, the Ti-contamination amount is found to be reduced to about 1/10 in the experiment examples 1, 2 and 3. Especially, in the experimental example 3 where the flow rates of the $H_2$ gas and the $N_2$ gas are set to be same, the highest Ti contamination amount reducing effect is obtained. Further, it is also proved that a sufficient Ti contamination amount reducing effect can be achieved even with a single $H_2$ gas.

Here, it is especially notable that, among the comparative examples 1 to 3, a Ti contamination amount reducing effect is hardly observed in the comparative example 2 where a single $N_2$ gas is used as the cleaning gas. That is, it is provided through this verification experiment that the $H_2$ gas dominantly contributes to the Ti contamination amount reducing effect in the dry cleaning process (process $S_3$) performed in the presence of the wafer in accordance with the example embodiment.

[Other example embodiments or modification examples]

According to the result of the verification experiment 1, the method (*i.e.,* the purging process performed in the presence of the wafer) of ventilating the inside of the chamber 10 without generating plasma within the chamber 10 while flowing the inert gas (Ar gas, $N_2$ gas) immediately after the dry etching process in the Low-k film etching process has the Ti contamination amount reducing effect, though the degree of such effect is incomparably much lower than the Ti contamination amount reducing effect obtained in the method of cleaning the inside of the chamber 10 by using the plasma of the cleaning gas containing the $H_2$ gas and the $N_2$ gas (*i.e.*, the dry cleaning process performed in the presence of the wafer). Accordingly, it is also possible to conduct this purging process, which is performed in the presence of the wafer, immediately before or after the dry cleaning process performed in the presence of the wafer in accordance with the example embodiment.

The example embodiments are not limited to the above-described plasma etching apparatus configured to apply dual frequency powers to the lower electrode. By way of example, the example embodiment may also be applicable to a plasma etching apparatus configured to apply a first high frequency power HF for plasma generation to the shower head (upper electrode) 60.

Further, the present example embodiments may not be limited to the capacitively coupled plasma etching apparatus but can be applied to various types of plasma etching apparatuses such as a microwave plasma etching apparatus, an inductively coupled plasma etching apparatus, a helicon wave plasma etching apparatus, etc. and, also, can be applied to other plasma processing apparatuses such as a plasma CVD apparatus, a plasma oxidizing apparatus, a plasma nitriding apparatus, a sputtering apparatus, etc. Further, the processing target substrate may not be limited to the semiconductor wafer but may be a photomask, a CD substrate, a print substrate, or one of various types of substrates for a flat panel display, an organic EL and a solar cell.

Other inventive effects or modification examples may be easily conceived by those skilled in the art. From the foregoing, it will be appreciated that various embodiments of the present disclosure have been described herein for purposes of illustration, and that various modifications may be made without departing from the scope of the present disclosure. Accordingly, the various embodiments disclosed herein are not intended to be limiting, with the true scope being indicated by the following claims.

**Claims**

1. A cleaning method of removing a Ti-containing reactant remaining in a processing vessel of a plasma processing apparatus, the cleaning method comprising:

    a first dry cleaning process of introducing a first cleaning gas containing a $H_2$ gas and a $N_2$ gas into the processing vessel in a depressurized state while evacuating the processing vessel; generating plasma by electrically discharging the first cleaning gas; allowing one of active species in the plasma to react with the Ti-containing reactant to generate a reaction product; and exhausting the reaction product from the processing vessel.

2. The cleaning method of Claim 1, wherein, after completing a dry etching process of etching a processing target object, in which an insulating layer as an etching target layer and a Ti-containing etching mask layer are formed, with a CF-based etching gas within the processing vessel, the first dry cleaning process is performed in the state that the processing target object is still provided within the processing vessel.

3. The cleaning method of Claim 2, wherein the insulating layer is a Low-k film.

4. The cleaning method of any one of Claims 1 to 3, further comprising:

    a second dry cleaning process of, in order to clean an inside of the processing vessel regularly, placing a dummy member having the same shape as that of the processing target object instead of the processing target object within the processing vessel; introducing a second cleaning gas into the processing vessel in a depressurized state while evacuating the processing vessel; generating plasma by electrically discharging the second cleaning gas; allowing one of active species in the plasma to react with a deposit or a contaminant within the processing vessel to generate a reaction product; and exhausting the reaction product from the processing vessel,
    wherein the first dry cleaning process is performed after completing the second dry cleaning process.

5. The cleaning method of any one of Claims 1 to 4, further comprising:

    a third dry cleaning process of, after completing the first dry cleaning process, unloading the processing target object from the processing vessel; introducing a third cleaning gas into the processing vessel in a depressurized state while evacuating the processing vessel where no processing target object is loaded; generating plasma by electrically discharging the third cleaning gas; allowing one of active species in the plasma to react with a deposit or a contaminant within the processing vessel to generate a reaction product; and exhausting the reaction product from the processing vessel.

6. The cleaning method of Claim 5, wherein the second cleaning gas contains an $O_2$ gas.

7. The cleaning method of any one of Claims 1 to 6, further comprising:

a first purging process of, prior to the first dry cleaning process, ventilating an inside of the processing vessel by flowing an inert gas into the processing vessel without generating plasma in the processing vessel.

8. The cleaning method of any one of Claims 1 to 7, further comprising:

a second purging process of, immediately after completing the first dry cleaning process, ventilating an inside of the processing vessel by flowing an inert gas into the processing vessel without generating plasma in the processing vessel.

9. The cleaning method of any one of Claims 1 to 8, wherein a flow rate ratio between the $H_2$ gas and the $N_2$ gas in the first cleaning gas is in a range from 1:0 to 1:3.

## *FIG. 1*

*FIG. 2A*

112
110
108
106
104
102
100

*FIG. 2B*

114 112
110
108
106
104
102
100

*FIG. 2C*

114
106
104
102
100

*FIG. 2D*

116
106
104
102
100

# FIG. 3

```
        ┌─────────────┐
        │    START    │
        └─────────────┘
               │
               ▼
   ┌───────────────────────────┐
   │  LOAD WAFER TO BE PROCESSED │──── S1
   └───────────────────────────┘
               │
               ▼
   ┌───────────────────────────┐
   │   PERFORM DRY ETCHING PROCESS │──── S2
   └───────────────────────────┘
               │
               ▼
   ┌───────────────────────────┐
   │ PERFORM DRY CLEANING PROCESS │──── S3
   │      IN PRESENCE OF WAFER    │
   └───────────────────────────┘
               │
               ▼
   ┌───────────────────────────┐
   │    UNLOAD PROCESSED WAFER   │──── S4
   └───────────────────────────┘
               │
               ▼
   ┌───────────────────────────┐
   │ PERFORM DRY CLEANING PROCESS │──── S5
   │      IN ABSENCE OF WAFER     │
   └───────────────────────────┘
               │
               ▼
        ┌─────────────┐
        │     END     │
        └─────────────┘
```

## FIG. 4

## FIG. 5

## FIG. 6

```
                    ┌──────────────┐
                    │    START     │
                    └──────┬───────┘
                           │
                           ▼
            ┌───────────────────────────┐
            │      LOAD DUMMY WAFER      │────S11
            └─────────────┬─────────────┘
                          │
                          ▼
            ┌───────────────────────────┐
            │      PERFORM REGULAR       │────S12
            │      CLEANING PROCESS      │
            └─────────────┬─────────────┘
                          │
                          ▼
            ┌───────────────────────────┐
            │ PERFORM DRY CLEANING PROCESS │────S13
            │   IN PRESENCE OF WAFER      │
            └─────────────┬─────────────┘
                          │
                          ▼
            ┌───────────────────────────┐
            │     UNLOAD DUMMY WAFER     │────S14
            └─────────────┬─────────────┘
                          │
                          ▼
            ┌───────────────────────────┐
            │ PERFORM DRY CLEANING PROCESS │────S15
            │    IN ABSENCE OF WAFER     │
            └─────────────┬─────────────┘
                          │
                          ▼
                    ┌──────────────┐
                    │     END      │
                    └──────────────┘
```

# FIG. 7

Europäisches
Patentamt

European
Patent Office

Office européen
des brevets

## EUROPEAN SEARCH REPORT

Application Number

EP 15 15 6143

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2004/013818 A1 (MOON KWANG-JIN [KR] ET AL) 22 January 2004 (2004-01-22) * paragraphs [0041] - [0056]; figure 2 * ----- | 1-9 | INV. H01L21/311 H01J37/32 |
| X | US 2004/007248 A1 (JANG SEONG SOO [KR] ET AL) 15 January 2004 (2004-01-15) * paragraphs [0018], [0019], [0022], [0023], [0025]; claims 1,3,6,8 * ----- | 1-9 | ADD. C23C16/44 |
| A | US 2007/184996 A1 (WENG CHENG-MING [TW] ET AL) 9 August 2007 (2007-08-09) * paragraphs [0040] - [0049]; figures 2,3 * ----- | 2,3 | |
| A | US 2012/237693 A1 (JACKSON MICHAEL [US] ET AL) 20 September 2012 (2012-09-20) * abstract * * paragraphs [0031], [0036], [0038] - [0042] * ----- | 4 | |
| A | EP 1 071 834 A1 (TOKYO ELECTRON ARIZONA INC [US]; TOKYO ELECTRON LTD [JP] TOKYO ELECTRO) 31 January 2001 (2001-01-31) * paragraphs [0040] - [0047]; figures 1,2 * ----- | 1,7,8 | TECHNICAL FIELDS SEARCHED (IPC) H01L H01J C23C |

The present search report has been drawn up for all claims

| Place of search | Date of completion of the search | Examiner |
|---|---|---|
| The Hague | 18 June 2015 | Szarowski, Anne |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 15 15 6143

This annex lists the patent family members relating to the patent documents cited in the above-mentioned European search report.
The members are as contained in the European Patent Office EDP file on
The European Patent Office is in no way liable for these particulars which are merely given for the purpose of information.

18-06-2015

| Patent document cited in search report | | Publication date | Patent family member(s) | | Publication date |
|---|---|---|---|---|---|
| US 2004013818 | A1 | 22-01-2004 | KR<br>US | 20040008873 A<br>2004013818 A1 | 31-01-2004<br>22-01-2004 |
| US 2004007248 | A1 | 15-01-2004 | JP<br>KR<br>TW<br>US | 2004036002 A<br>20040006481 A<br>I319896 B<br>2004007248 A1 | 05-02-2004<br>24-01-2004<br>21-01-2010<br>15-01-2004 |
| US 2007184996 | A1 | 09-08-2007 | NONE | | |
| US 2012237693 | A1 | 20-09-2012 | NONE | | |
| EP 1071834 | A1 | 31-01-2001 | CN<br>DE<br>DE<br>EP<br>JP<br>JP<br>KR<br>TW<br>US<br>WO | 1319146 A<br>69903531 D1<br>69903531 T2<br>1071834 A1<br>3730865 B2<br>2002512307 A<br>100421572 B1<br>504522 B<br>6635569 B1<br>9954522 A1 | 24-10-2001<br>21-11-2002<br>18-06-2003<br>31-01-2001<br>05-01-2006<br>23-04-2002<br>09-03-2004<br>01-10-2002<br>21-10-2003<br>28-10-1999 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• JP 2003282539 A